Europäisches Patentamt

European Patent Office

Office européen des brevets

(11) Publication number: **0 152 334**
**B1**

# EUROPEAN PATENT SPECIFICATION

(45) Date of publication of patent specification: **09.08.89**

(51) Int. Cl.⁴: **H 01 L 23/54, H 01 L 23/28**

(21) Application number: **85400164.1**

(22) Date of filing: **01.02.85**

(54) **Semiconductor structure having alpha particle resistant film and method of making the same.**

(30) Priority: **09.02.84 US 578408**

(43) Date of publication of application:
**21.08.85 Bulletin 85/34**

(45) Publication of the grant of the patent:
**09.08.89 Bulletin 89/32**

(84) Designated Contracting States:
**DE FR GB IT NL**

(56) References cited:
**EP-A-0 028 490**
**EP-A-0 045 561**
**US-A-4 388 132**

**ELECTRONIC DESIGN, vol. 28, no. 24, 1980, page 36, Waseca, Minnesota; Denville, New Jersey US; J. McLEOD:"Polyimide film - not liquid - shields RAMs from alpha particles"**

**PATENTS ABSTRACTS OF JAPAN, VOL. 8, NO. 81 (E-238)1518r, 13TH APRIL 1984 & JP-A-59-2353**

(73) Proprietor: **FAIRCHILD SEMICONDUCTOR CORPORATION**
**10400 Ridgeview Court P.O. Box 1500**
**Cupertino, California 95014 (US)**

(72) Inventor: **Brueggeman, Michael**
**1012 Bonita Avenue**
**Mountain View California 94040 (US)**
Inventor: **Phy, William**
**25616 Moody Road**
**Los Altos Hills California 94022 (US)**
Inventor: **Clark, James**
**101 Chateau la Salle**
**San Jose California 95111 (US)**

(74) Representative: **Dipl.-Ing. H. Marsch Dipl.-Ing. K. Sparing Dipl.-Phys.Dr. W.H. Röhl Patentanwälte Rethelstrasse 123 Postfach 14 02 68 D-4000 Düsseldorf (DE)**

(56) References cited:
**PATENTS ABSTRACTS OF JAPAN, VOL. 7, NO. 132 (E-180)1277r, 9TH JUNE 1983 & JP-A-58-48 950**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

Background of the invention

The present invention relates generally to integrated circuit devices, and more particularly, to a method for making a semiconductor structure having an alpha particle resistant film and to such semiconductor structures.

In the manufacture of integrated circuits, semiconductor wafers containing many separate integrated circuits are fabricated and then cut into individual integrated circuits, often individually referred to as die. It is well known that the die may be adversely affected by alpha particles, such as those alpha particles which are emitted from metals, ceramics, as well as some plastic materials. When such alpha particles impinge on a semiconductor memory cell, a change may result in the state of a bit within the memory cell, resulting in a phenomenon known in the industry as a "soft bit error". Although this type of error may be corrected using known error correction and detection schemes, multiple "soft bit errors" may create conditions in which such schemes are unable to provide a desired correction. Thus, it is desirable to protect integrated circuit dies which are subject to degradation by alpha particles.

The need to provide alpha particle protection has become more critical as the density of integrated circuits increases. Although there are available methods for providing some degree of alpha particle protection, none of these methods is totally satisfactory inasmuch as such methods present certain disadvantages and/or require cumbersome processing techniques. For example, one technique includes the application of liquid polyimide on the individual die after the die has been attached to a substrate and wire bonded. This technique requires substantial labor while providing a high die rejection rate. Further, this liquid system does not reliably provide a sufficient thickness of the protective coating near the edges of the area to be protected. Other techniques attempt to screen print liquid polyimide in a pattern on the semiconductor wafer itself. However, such techniques have been hampered by the inability to print polyimide in sufficient thicknesses. Generally, in addition to their high failure rate, steps of dispensing and applying liquid or paste are difficult to automate.

US—A—4,388,132 discloses a method of providing alpha particle barriers over selected regions of a semiconductor wafer. The method includes the steps of placing a droplet of adhesive on the wafer surface, dropping the barrier film made of a polyimide on the adhesive droplet, and properly aligning the film relative to the wafer surface in accordance with the perimeters of the individual dies.

It is evident that such method is time-consuming and hardly suited for automation.

It is the object of the present invention to provide a method for making a semiconductor structure including alpha particle barriers for those device regions which are subject to degradation upon alpha irradiation.

According to the present invention, the method of making a semiconductor structure, comprising the step of providing a semiconductor wafer having a pair of opposing major surfaces, one of the major surfaces including a plurality of integrated circuit devices, is characterized by the step of applying a preformed patterned alpha particle resistant film to the semiconductor wafer so that film portions of the patterned film are aligned and bonded with the selected device regions of the integrated circuit devices which are subject to degradation by alpha particles.

For better understanding of the invention, reference may be had to the following description, taken in conjunction with the accompanying drawings, wherein:

Figure 1 is an isometric view showing an exemplary semiconductor wafer including a plurality of integrated circuits therein.

Figure 1A is a sectional view taken along line A—A of Figure 1.

Figure 2 is an isometric view in which an alpha particle resistant film is disposed on a carrier film for subsequent use in the method of the present invention.

Figure 3 is an isometric view, taken as in Figure 2, showing the alpha particle resistant film after it has been patterned in accordance with the method of the present invention.

Figure 4 is an isometric view, showing one form of the method of the present invention in which the patterned alpha particle resistant film is aligned with respective critical cell regions of the integrated circuits.

Figure 5 is an isometric view showing one form of the semiconductor structure after the patterned alpha particle resistant film is applied to critical cell regions of the integrated circuit.

Figure 5A is a sectional view taken along line A—A of Figure 5 showing one form of the semiconductor device which now includes an alpha particle resistant film portion attached to the critical cell regions thereof.

Detailed description of the invention

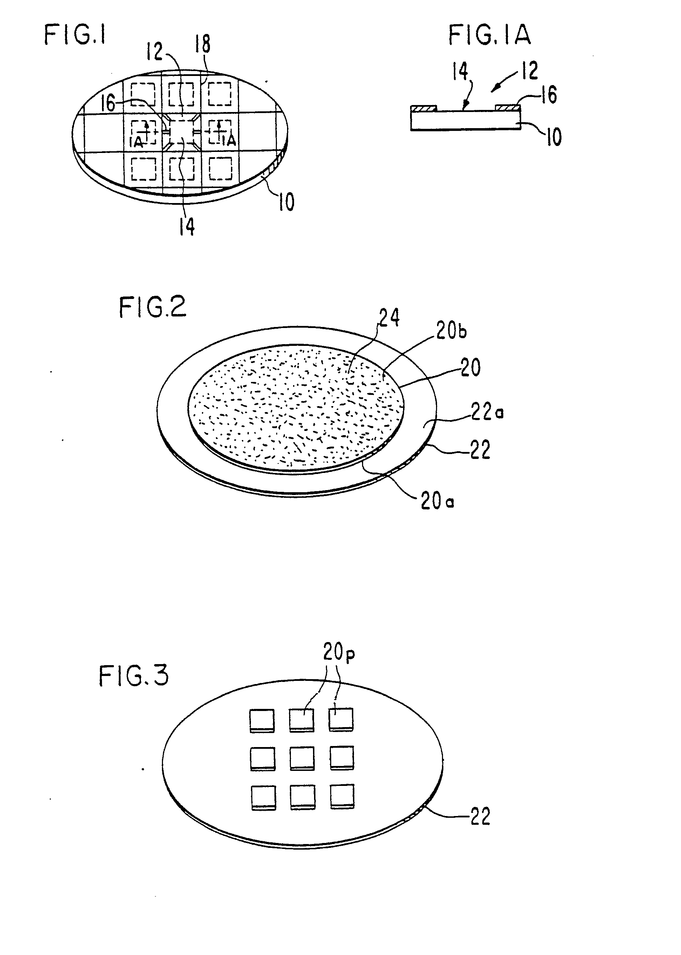

Referring initially to Figure 1, an exemplary semiconductor wafer 10 includes a plurality of integrated circuit devices 12, individually referred to as die. Each of the integrated circuit devices 12 includes a critical cell region 14 e.g., memory region, and a plurality of bond pads 16. As is well known, scribe lines 18 are later used in separating e.g. sawing, the wafer 10 so as to result in a plurality of individual dies 12, such as shown in Figure 1A. For purposes of clarity, although only a few exemplary integrated circuits 12 are shown in Figure 1; a typical wafer may include as many as two thousand integrated circuits 12, each having as many as twenty four bonding pads 16 attached thereto.

As described previously, the critical cell region 14 of the integrated circuit 12 is often subject to degradation by alpha particles.

Referring now to Figure 2 an alpha particle resistant material is provided in the form of a film 20. The alpha particle resistant film 20 is of an area at least as great as, preferably greater than, the semiconductor wafer 10. The alpha particle resistant material is selected from those well known materials which have an alpha particle resistance in the range of from greater than about 0 MeV to about 10 MeV. Preferably, the alpha particle resistant material comprises a fully imidized polyimide, such as the one commercially available from Dupont under the designation Kapton.™ Typically, the thickness of the film 20 is in the range of from about 50 microns to about 100 microns, preferably about 75 microns.

For handling ease, a major surface 20a of the alpha particle resistant film 20 is shown as being removably disposed on a surface 22a of carrier film 22 which may, for example, comprise a material such as polyoelefin. The remaining major surface 20b of the alpha particle resistant film 20 is subsequently used to contact the critical cell regions 14 in a manner to be described later. This remaining surface 20b is preferably coated with a thermal cure adhesive 24, resulting in the structure shown in Figure 2. An exemplary thermal cure adhesive 24 comprises acrylic adhesive, commercially available under the designation Rogers 10,000 from Rogers Corp.

Next, as shown in Figure 3, an appropriate pattern corresponding to the pattern of critical cell regions 14 in Figure 1, is provided in the alpha particle resistant film 20. This results in a plurality of alpha particle resistant film portions 20p, each of which respectively correspond to the critical cell regions 14 shown in Figure 1.

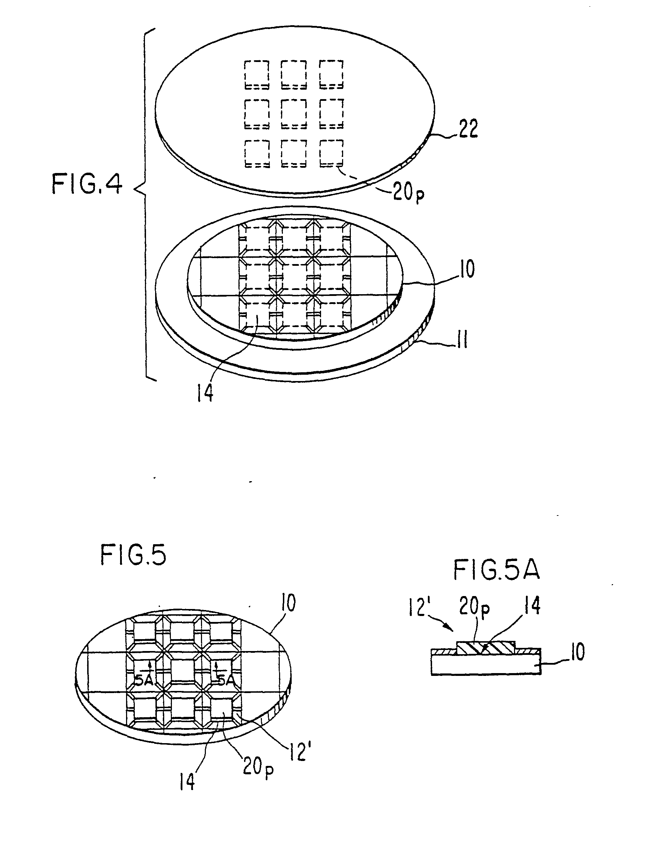

Next, as shown in Figure 4, the now patterned alpha particle resistant film 20 (film portions 20p) is aligned with the semiconductor wafer 10 such that each of the critical cell regions 14 of the water 10 is respectively aligned with an alpha particle resistant film portion 20p. For handling convenience, it is preferable to employ a wafer carrier 11, which may, for example, comprise interlocking rings. The alignment is typically obtained through the use of well known techniques such as optical alignment.

When the alignment is completed, the structures shown in Figure 4 are brought together and heat and pressure may be applied to secure the alpha particle resistant film portions 20p to the critical cell regions 14. For example, heat in the range of from about 100°C to about 300°C and pressure in the range of from about 1 PSI (1) to about 30 PSI (2) may be applied.

$$(1) \triangleq 0,07 \text{ kg/cm}^2$$

$$(2) \triangleq 2,1 \text{ kg/cm}^2$$

After the film portions 20p have been bonded to the critical cell regions 14, the carrier film 22 is removed, e.g., peeled off, resulting in the structure shown in Figures 5, 5A. At this point in the method, it is preferable to fully cure and bond the remaining film portions 20p to the critical cell regions 14. For example, such curing and bonding may include the application of heat in the range of from about 275°C to 450°C. Thus, as shown in Figure 5A, predetermined ones (critical cell regions 14) of the integrated circuits 12' now include an alpha particle resistant film 20p attached thereto. The individual die 12' may then be tested, identified and separated in the usual manner e.g. sawed.

Although the present invention has been described as using a polyimide material for the alpha particle resistant film 20, other materials may be substituted therefor. For example, such materials may include polyester.

In addition, although the invention has been described in connection with integrated circuit devices in which the critical cell region comprise a single central region, certain applications may present more complex critical cell region configurations and/or a plurality of separate such regions for individual integrated cell devices. In this connection, the invention is equally applicable to such configurations inasmuch as conventional techniques can be utilized to provide the desired pattern in the alpha particle resistant film prior to application of such film to the semiconductor wafer.

Further, although the present invention has been described as including a carrier film for the alpha particle resistant film in which the carrier film comprises polyoelefin, other materials may be substituted therefor. For example, one such material is poly-vinyl-chloride. However, it is preferable that the carrier film and the alpha particle resistant film have a relation therebetween wherein the alpha particle resistant film has a relative release characteristic in which it is more strongly attached to the critical cell regions and less strongly attached to the carrier film.

It is apparent that an advantage of the present invention is that custom patterning is provided for each selected integrated circuit device such that only the critical cell areas are covered. Thus, bond pads, scribe streets, etc. are not covered by the film. Another advantage of this invention is that, after the application and cure of the alpha particle resistant film portions, probe testing can still be performed. This is in contrast to conventional techniques in which bond pads are covered by an insulating material.

Another advantage of the present invention is, that in addition to providing alpha protection, the process provides protection of the device from mechanically caused damage. This is particularly important when assembly processes are employed which result in contact to the active (first) surface of the device.

While the present invention has been described with reference to specific embodiments thereof, it will be obvious to those skilled in the art that various changes and modifications may be made without departing from the invention in its broader aspects. It is contemplated in the appended claims to cover all variations and modifications of the invention which come within the true spirit and scope of our invention.

## Claims

1. A method of making a semiconductor structure, comprising the step of:
   providing a semiconductor wafer (10) having a pair of opposing major surfaces, one of the major surfaces including a plurality of integrated circuit devices (12), and
   characterized by the step of:
   applying a preformed patterned alpha particle resistant film (20) to the semiconductor wafer (10) so that film portions (20p) of the patterned film (20) are aligned and bonded with the selected device regions (14) of the integrated circuit devices, which are subject to degradation by alpha particles.

2. A method in accordance with Claim 1 characterized in that the alpha particle resistant film comprises a material which has an alpha particle resistance in the range of from greater than about 0 MeV to about 10 MeV.

3. A method in accordance with Claim 1 or 2 wherein the alpha particle resistant film includes a pair of opposing major surfaces, and characterized by the step of providing a carrier film having a major surface thereof for removably receiving one of the surfaces of the alpha particle resistant film.

4. A method in accordance with Claim 3 characterized by the step of providing the other major surface of the alpha particle resistant film with an adhesive prior to the step of applying the alpha particle resistant film to the predetermined ones of the device regions.

5. A method in accordance with Claims 4 characterized in that the alpha particle resistant film has a relative release characteristic wherein it is strongly attached to the predetermined ones of the device regions and less strongly attached to the carrier film.

6. A method in accordance with any of Claims 1 to 4 characterized in that the alpha particle resistant film comprises polyimide.

7. A method in accordance with any of Claims 1 to 6 characterized in that the alpha particle resistant film has a thickness of from about 50 microns to about 100 microns.

8. A method in accordance with any of Claims 3 to 7 characterized in that the carrier film comprises polyolefine.

9. A method in accordance with any of Claims 3 to 8 characterized in that the carrier film comprises poly-vinyl-chloride.

10. A method in accordance with any of Claims 1 to 9, characterized by the step of probe testing at least some of the plurality of integrated circuits after said alpha particle resistant film is applied.

11. A method in accordance with Claim 10 characterized by the step of separating individual ones of the integrated circuits after the step of probe testing.

## Patentansprüche

1. Halbleiterstruktur-Herstellverfahren, umfassend den Schritt Bereitstellen eines Halbleiterwafers (10) mit einem Paar einander gegenüberliegender Hauptflächen, von denen eine eine Mehrzahl integrierter Schaltkreise (12) enthält, und gekennzeichnet durch den Schritt
   Aufbringen eines muster-vorgeformten alphateilchenresistenten Films (20) auf den Halbleiterwafer (10) derart, daß Filmabschnitte (20p) des Films (20) mit den ausgewählten Bereichen (14) der integrierten Schaltkreise, die durch Alphateilchen verschlechtert würden, ausgefluchtet und zum Anhaften gebracht werden.

2. Verfahren nach Anspruch 1, dadurch gekennzeichnet, daß der alphateilchenresistente Film ein Material umfaßt, das ein Alphateilchenresistenz im Bereich von mehr als etwa 0 MeV bis etwas 10 MeV hat.

3. Verfahren nach Anspruch 1 oder 2, bei dem der alphateilchenresistente Film ein Paar einander gegenüberliegender Hauptoberflächen aufweist, und gekennzeichnet durch den Schritt des Bereitstellens eines Trägerfilmes, der eine seiner Hauptoberflächen für die ablösbare Aufnahme einer der Hauptoberflächen des alphateilchenresistenten Films hat.

4. Verfahren nach Anspruch 3, gekennzeichnet durch den Schritt des Aufbringens eines Haftmittels auf die andere Hauptoberfläche des alphateilchenresistenten Films vor dem Schritt des Aufbringens des alphateilchenresistenten Films auf die vorgegebenen Schaltkreisbereiche.

5. Verfahren nach Anspruch 4, dadurch gekennzeichnet, daß der alphateilchenresistente Film eine relative Ablösecharakteristik hat, bei der er stärker an den vorgegebenen Schaltkreisbereichen haftet und schwächer an dem Trägerfilm.

6. Verfahren nach einem der Ansprüche 1 bis 4, dadurch gekennzeichnet, daß der alphateilchenresistente Film Polyimid umfaßt.

7. Verfahren nach einem der Ansprüche 1 bis 6, dadurch gekennzeichnet, daß der alphateilchenresistente Film eine Dicke von etwa 50 Mikron bis etwa 100 Mikron besitzt.

8. Verfahren nach einem der Ansprüche 3 bis 7, dadurch gekennzeichnet, daß der Trägerfilm Polyolefin umfaßt.

9. Verfahren nach einem der Ansprüche 3 bis 8, dadurch gekennzeichnet, daß der Trägerfilm Polyvinylchorid umfaßt.

10. Verfahren nach einem der Ansprüche 1 bis 9, gekennzeichnet durch den Schritt des Sondentestens mindestens einiger der Mehrzahl integrierter Schaltkreise nach dem Aufbringen des alphateilchenresistenten Films.

11. Verfahren nach Anspruch 10, gekennzeichnet durch den Schritt des Abtrennens einzelner integrierter Schaltkreise nach dem Schritt des Sondentestens.

## Revendications

1. Procédé de fabrication d'une structure semi- conductrice, comprenant l'étape consistant à:

—fournir une plaquette semi-conductrice (10) ayant une paire de faces principales opposées, l'une des faces principales comprenant une pluralité de dispositifs de circuit intégré (12), et caractérisé par l'étape consistent à:

—appliquer sur la plaquette semi conductrice (10) un film résistant aux particules alpha préformé et structuré (20) de manière que des portions (20p) du film structuré (20) soient alignées et fixées avec les régions sélectionnées (14) des dispositifs de circuit intégré qui sont sujettes à dégradation par des particules alpha.

2. Procédé selon la revendication 1, caractérisé en ce que le film résistant aux particules alpha comprend un matériau qui a une résistance aux particules alpha comprise entre 0 MeV environ et 10 MeV environ.

3. Procédé selon la revendication 1 ou 2 dans lequel le film résistant aux particules alpha comprend une paire de faces principales opposées, et caractérisé par l'étape consistant à fournir un film support ayant une face principale pour recevoir de manière amovible l'une des faces du film résistant aux particules alpha.

4. Procédé selon la revendication 3, caractérisé par l'étape consistant à munir l'autre face principale du film résistant aux particules alpha d'un adhésif avant l'étape consistant à appliquer le film résistant aux particules alpha sur les régions prédéterminées du dispositif.

5. Procédé selon la revendication 4, caractérisé en ce que le film résistant aux particules alpha a une caractéristique de décolement relatif selon laquelle il est fixé plus fortement aux régions prédéterminées du dispositif et moins fortement au film support.

6. Procédé selon l'une quelconque des revendications 1 à 4, caractérisé en ce que le film résistant aux particules alpha comprend du polyimide.

7. Procédé selon l'une quelconque des revendications 1 à 6, caractérisé en ce que le film résistant aux particules alpha a une épaisseur comprise entre 50 microns environ et 100 microns environ.

8. Procédé selon l'une quelconque des revendications 3 à 7, caractérisé en ce que le film support comprend du polyolefine.

9. Procédé selon l'une quelconque des revendications 3 à 8, caractérisé en ce que le film support comprend du chlorure de polyvinyle.

10. Procédé selon l'une quelconque des revendications 1 à 9, caractérisé par l'étape consistant à tester à l'aide d'une sonde au moins certains des circuits intégrés de la pluralité de circuits intégrés après que ledit film résistant aux particules alpha a été appliqué.

11. Procédé selon la revendication 10, caractérisé par l'étape consistant à séparer les circuits intégrés individuels après l'étape de test à l'aide d'une sonde.

EP  0 152 334  B1

FIG.1

FIG.1A

FIG.2

FIG.3

FIG.4

22

20p

10

11

14

FIG.5

10

5A          5A

12'

14          20p

FIG.5A

12'   20p   14

10